# EUROPÄISCHE PATENTANMELDUNG

(11) **EP 2 043 172 A2**
(43) Veröffentlichungstag der Anmeldung: **01.04.2009**
(21) Anmeldenummer: 08105178.1
(22) Anmeldetag: 29.08.2008
(51) Int. Cl.: H01L 41/053, F02M 51/00

(54) **Vorrichtung zur Kontaktierung von Kontaktstiften von Piezoaktoren mit Anschlusselementen**

(30) Priorität: 27.09.2007 DE 102007000788
(71) Anmelder: Siemens Aktiengesellschaft, 80333 München (DE)
(72) Erfinder: Bachmaier, Georg, 80538 München (DE); Ebelsberger, Gerit, 81737 München (DE); Höge, Michael, 85540 Haar (DE); Mock, Randolf, 85662 Hohenbrunn (DE); Vontz, Thomas, 81539 München (DE); Zöls, Wolfgang, 94496 Ortenburg (DE)

(57) **Zusammenfassung**

Vorrichtung zur Kontaktierung von Kontaktstiften/PIN (4) von Piezoaktoren mit Anschlusselementen zum elektrischen Anschluss von Piezoaktoren nach außen, wobei ein Kunststoffring (60) stirnseitig auf einer Kopfplatte (8) eines Piezostapels (7) positioniert ist, Kontaktstifte (4) durch den Kunststoffring (60) hindurchgeführt sind und nach außen hervorragen, mindestens ein aus einem elektrischen Leiter gebildetes im wesentlichen U-förmig ausgeformtes Verbindungsteil/Leadframe (1) mit seinem mittleren Steg in den Kunststoffring annähernd vollständig eingegossen ist, sodass die nach oben gerichteten Schenkel des Verbindungsteils (1) an sowohl einem Kontaktstift (4) als auch an einem Anschlusselement/Terminaladapter (5) zur Verschweißung positioniert sind, und
- das Verbindungsteil (1) unter Beibehaltung seiner U-Form bei analoger Positionierung in Aussparungen im Kunststoffring (60) derart eingepasst ist, dass ein Schenkel (14) mittels einer Führung (10) und das angrenzende Teil des mittleren Stegs (13) mittels einer Spielpassung (12) aufgenommen sind, und der gegenüberliegende Schenkel (14) und das an diesen angrenzende Teil (13) des mittleren Stegs in umgekehrter Weise gelagert sind,
- das Verbindungsteil (1) im mittleren Steg, etwa mittig einen Energiespeicher (9) zur Dämpfung von Schwingungen aufweist.

## Beschreibung

Die Erfindung betrifft die Kontaktierung von Piezoaktoren beziehungsweise von Piezostapeln für Piezoeinspritzventilen, die in Otto-Direkt-Einspritzmotoren verwendet werden. Dabei wird insbesondere die Kontaktierung von Kontaktstiften, den sogenannten PINs, die jeweils stirnseitig in einem Aktor hervorragen bis hin zu einem Steckeranschluss betrachtet.

Im Serienbetrieb ergeben sich an den PINs des Piezoaktors sowie an vorhandenen Kontaktierungen Bruchstellen aufgrund von zu hoher mechanischer Spannungen oder Schwingungen. Hierbei sind sowohl die Bauteile, die PINs des Piezoaktors, als auch deren Verbindungselemente sowie deren Schweißverbindungen betroffen.

Es ist bekannt Hochdruckdirekteinspritzventile für Benzinmotoren mit Piezoaktoren zu steuert. Die in Piezoaktoren eingesetzten Piezostapel, auch bekannt unter dem Namen ,Piezostack', werden elektrisch angesteuert und benötigen entsprechende Zuleitungen. Von der Seite eines Piezostapels kommend, wird dazu in der Regel an dessen Stirnseite ein Paar von Kontaktstiften, sogenannten PINs vorhanden sein, die weiterführend nach außen über Verbindungselemente beispielsweise mit Steckerverbindungen und dergleichen, auch bezeichnet als Terminal-Adapter, verbunden werden.

Um einen Terminal-Adapter elektrisch mit zwei PINs zu verbinden müssen die PINs an der Stirnseite eines Aktors umfangsseitig mit gegenseitigem Abstand an einer gemeinsamen Position angebracht sein und sich achsparallel erstrecken. Es ist somit in der Regel vorgesehen einen der PINs in queraxialer Richtung in die Nähe des anderen PINs zu verlagern bzw. zu verlängern. Hierzu wird ein Verbindungselement eingesetzt, sogenanntes Leadframes. Dieses ist in etwa U-förmig ausgebildet, und wird derart eingesetzt, dass ein Schenkel parallel zu dem zu versetzenden PIN positioniert ist und der weitere Schenkel am Ort des weiteren PINs parallel zu diesem gelagert ist. Nun kann ein Terminal-Adapter mit jeweils einem PIN leitend verbunden werden, insbesondere verschweißt werden.

Der gesamte Aufbau eines Piezoaktors sieht stirnseitig zunächst eine Kopfplatte vor auf der nach außen hin ein Kunststoffring positioniert ist, welche im Wesentlichen zur Führung und Halterung von PINs dient. Ein Leadframe ist in bekannter Art in dem Kunststoffring vergossen, wobei die Schenkel des U-förmigen Bauteiles stirnseitig nach außen hervorragen. Ein PIN wird mit dem Leadframe, welcher in dem Kunststoffring eingegossen ist, verschweißt. Der Terminal-Adapter wird ebenfalls am Leadframe jedoch am anderen Schekel angeschweißt, dem Schenkel der sich in der Nähe des weiteren PINs befindet, der parallel dazu ausgerichtet. Somit wird die elektrische Verbindung an der Kopfseite eines Piezoaktors an einer einzigen Position angeboten.

Nachteil bei Systemen entsprechend dem Stand der Technik sind unterschiedliche Funktionen und Materialeigenschaften von Kunststoffring und Leadframe. Da dies zu wesentlichen mechanischen Spannungen führt, können im System selbst Ausfälle durch Bruch auftreten. Im Wesentlichen werden durch von außen aufgebrachte Schwingungen Bauteile in der Art belastet, dass die Lebensdauer sehr gering ist.

Die Erfindung liegt die Aufgabe zugrunde eine insgesamt Störunanfällige stirnseitige Kontaktierung von PINs von Piezoaktoren mit nach außen führenden Verbindungselementen zur elektrischen Kontaktierung bereitzustellen.

Die Lösung dieser Aufgabe geschieht durch eine Vorrichtung entsprechend Patentanspruch 1. Vorteilhafte Ausgestaltungen sind den unteren Ansprüchen zu entnehmen.

Der Erfindung liegt die Erkenntnis zugrunde, dass eine Modifizierung des Kunststoffringes und eine besondere Lagerung eines Leadframes im Kunststoffring, sowie die Ausbildung eines Energiespeichers zur Aufnahme von zeitlich variablen Kräften, die am Leadframe wirken, eine Lösung der oben beschriebenen Probleme erbringt. Die durch Eingießen eines Leadframes in den Kunststoffring bisher vorhandene mechanische Überbestimmung wird vermieden, indem auf eine im Wesentlichen schwimmende Aufnahme des Leaadframes in den Kunststoffring umgestellt wird. Dabei wird ein Leadframe in Aussparungen in einem Kunststoffring eingepasst und gezielt geführt, beziehungsweise zur Einhaltung vorgegebener Positionen im Freiheitsgrad für Positionsänderungen eingeschränkt, in Längsführungen gehalten oder in Spielpassungen lose aufgenommen. Zusätzlich wird ein Energiespeicher im Leadframe eingebaut, der die auftretenden mechanischen Spannungen reduzieren beziehungsweise abbauen kann.

Der im Leadframe vorhandene Energiespeicher ist in vorteilhafter Weise durch eine mittig im Leadframe angebrachte federnde Biegung des elektrischen Leiters verwirklicht, wobei diese Biegung bis 180 Grad annehmen kann.

Der Kunststoffring ist in vorteilhafterweise aus Polyamid dargestellt. Der Kunststoffring ist aus Gründen der Montagevereinfachung zweigeteilt, in einem oberen Kunststoffring und in einem unteren Kunststoffring.

Durch Vermeidung einer statischen Überbestimmung und durch Einbau eines Energiespeichers im Leadframe werden die mechanischen Spannungen im Betrieb im Leadframe und an einem PIN deutlich gesenkt.

Im Folgenden werden anhand der begleitenden Figuren Ausführungsbeispiele beschrieben.
Die schematischen Figuren zeigen jeweils folgendes:
- Fig. 1: zeigt einen erfindungsgemäßen Stützring aus Kunststoff mit entsprechenden Aussparungen, insbesondere in zweigeteilter Form,
- Fig. 2: zeigt eine Ausführung entsprechend dem Stand der Technik mit vollständig eingegossenem mittleren Teil des U-förmigen Leadframes,
- Fig. 3: zeigt einen Kunststoffring 60 in zweigeteilter Form mit einem darin aufgenommenen Leadframe 1,
- Fig. 4: zeigt eine Aufnahme eines Schenkels 14 eines Leadframes 1 im Vordergrund mit einer Spielpassung 12, so dass für den Schenkel 14 ein Freiheitsgrad in horizontaler Richtung vorhanden ist.

Im bekannten Stand der Technik wird ein Verbindungsteil / Leadframe zumindest mit seinem mittleren Steg vollständig in einem Kunststoffring vergossen. Diese Positionierung und Befestigung des Leadframes dient dazu, eine leitende Verbindung zwischen den Anschlussstiften beziehungsweise Kontaktstiften von Piezoaktoren mit den beispielsweise Steckerstiften über entsprechende nach Außen führende Leitungen herzustellen. Die Notwendigen jeweils zwischen Bauelementen vorhandenen Verbindungen sind in der Regel Schweißverbindungen. Insgesamt sollen die Kontaktstifte / PINs die durch den Fertigungsprozess teilweise gebogen sind wieder auf eine definierte Lage zur nachfolgenden Herstellung einer Schweißverbindung gebracht werden. Somit wird ein Leadframe als Verbindungsteil von einerseits einem PIN zu andererseits einem Anschlusselement / Terminal-Adapter verwendet.

Bei der vorliegenden Erfindung ist der Kunststoffring 60 zweigeteilt in einen oberen Kunststoffring 61 und einen unteren Kunststoffring 62. Es werden die Funktionen von einerseits dem Kunststoffring und andererseits dem Leadframe voneinander entkoppelt. Dazu werden die Lagerarten und deren Funktionen sowie die Ausdehnungen im Bereich entlang des Leadframes im Einzelnen betrachtet. Statische Überbestimmtheiten durch Eingießen eines größeren Bereiches eines Leadframes im Kunststoffring wie im Stand der Technik vorgesehen, werden bei der Erfindung vermieden. Zusätzlich wird ein Energiespeicher im Leadframe mittig ausgebildet, der die mechanischen Spannungen puffert, dämpft oder in ihrer nachteiligen Wirkung reduziert. Dieser Energiespeicher 9 ist entsprechend elastisch verformbar.

Durch die Vermeidung von statischen Überbestimmungen und durch den Einsatz eines Energiespeichers im Leadframe werden mechanische Spannungen zwischen Kunststoffring und Leadframe und zwischen Kunststoffring und PIN deutlich gesenkt. Es ergibt sich dabei eine Reduzierung der Spannung um den Faktor zehn. Analog dazu verhält sich der PIN. Somit kann ein Abriss einer Schweißverbindung zwischen Leadframe und PIN vermieden werden.

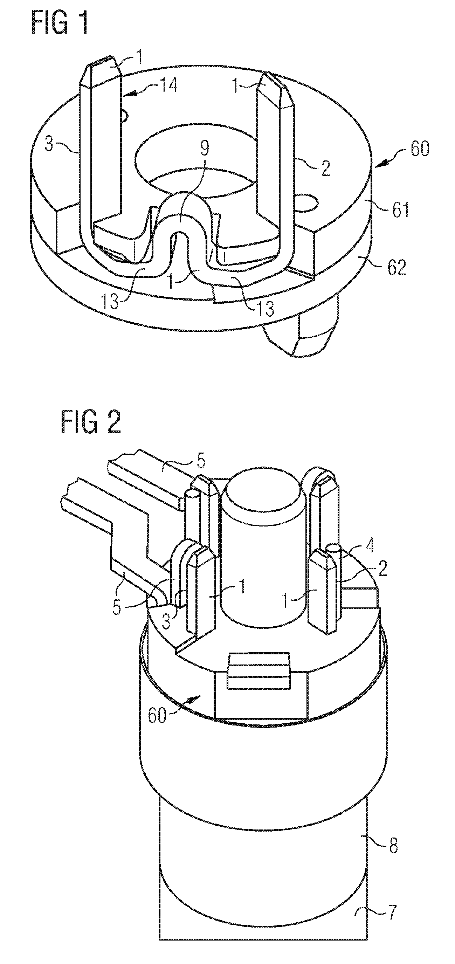

Fig. 2 zeigt eine Ausgestaltung entsprechend dem Stand der Technik wobei das Verbindungsteil, Leadframe 1, fast vollständig von dem Material des Kunststoffringes 60 eingeschlossen ist. Der Leadframe 1 dient zur Kontaktierung zwischen einem Kontaktstift/ PIN 4 und einem Anschlusselement / Terminal-Adapter 5. Die Funktion des Kunststoffringes 60 ist im Wesentlichen auf die Abstützung beziehungsweise Ausrichtung des Leadframes gerichtet. Eine genaue Ausrichtung entsprechen der Schweißpartner ist notwendig um den Verbindungsvorgang reibungslos ablaufen zu lassen. Weiterhin ist in Figur 2 der Grundkörper des Piezostapels 7 angedeutet, dessen Kopfplatte 8 an Ihrer oberen Stirnseite den Kunststoffring beziehungsweise Stützring aufnimmt.

Figur 1 zeigt eine Darstellung entsprechend der Erfindung in der das Leadframe 1 im Kunststoffring 60 bestehend aus oberem Kunststoffring 61 und unterem Kunststoffring 62 schwimmend gelagert ist. Ein vollständiges vergießen des Leadframes 1 findet nicht statt. Zur Erfüllung der Stütz- und Ausrichtungsfunktion des Stützrings 60 weist dieser entsprechende Aussparungen auf, in die der vorbereitete Leadframe 1 eingepasst wird. Dabei ist zumindest ein Schenkel 14 des Leadframes 1 in Umfangsrichtung eingeklemmt und annähernd achsparallel ausgerichtet. Somit können sowohl die Schweißstelle 2 für die Verbindung zum PIN als auch die Schweißstelle 3 für die Verbindung zum Terminal-Adapter 5 gut zueinander ausgerichtet werden. Der dem gerade beschriebenen Schenkel gegenüberliegende zweite Schenkel des Leadframes weist vorzugsweise eine in Umfangsrichtung gesehen Spielpassung auf, so dass unterschiedliche Ausdehnungen unterschiedlicher Materialien bei Temperaturschwankungen nicht zu Verklemmungen irgendwelcher Art mit resultierenden Schädigungen führen können. Sollte die Belastung stark ansteigen, ist das Leadframe am mittleren Steg des U-förmigen Bauteils mit einem sogenannten Energiespeicher 9 versehen, der federnde Eigenschaften aufweist, der durch eine ca. 180 Grad betragende Windung dargestellt ist. Auch diese Möglichkeit wärmebedingte Kräfte aufzufangen, ohne das Risiko des Materialbruchs, kann durch die entsprechend schwimmende Lagerung des Leadframes mit dem zusätzlichem Energiespeicher ausgenutzt werden.

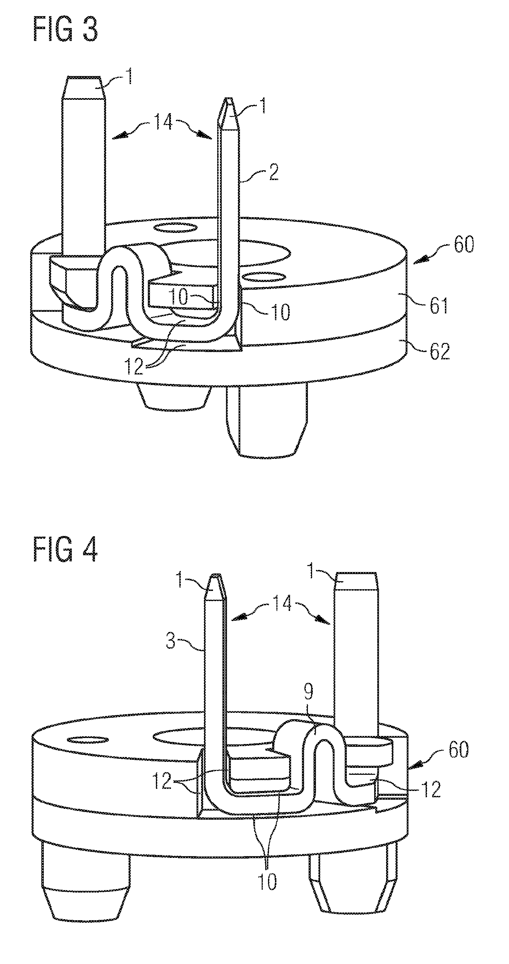

Zur Lagerung in achsparalleler Richtung relativ zur zentralen Achse der gesamten Anordnung sind die Bereiche des Leadframes 1 zu betrachten, die zwischen dem zentral positionierten Energiespeicher 9 und in dem jeweilig angrenzenden Schenkel des Leadframes 1 positioniert sind. Vorzugsweise ist dabei entsprechend Figur 3 eine Führung durch eine Spielpassung 12 realisiert, so dass der hier vorhandene mittlere Steg des Leadframes 1, sowohl in Umfangsrichtung als auch in paralleler Richtung frei bewegbar ist. Die Führung 10 wird jedoch durch eine geringfügige Klemmung realisiert, so dass der Schenkel 14 des Leadframes 1 an dieser Stelle lediglich in achsparalleler Richtung relativ zum Kunststoffring 60 verschiebbar ist.

Figur 4 zeigt in Anlehnung an Figur 3 relativ zum Energiespeicher 9 eine gegenüberliegende Führung 10 für den mittleren Steg 13. Der Schenkel 14 wird hier mittels einer Spielpassung 12 entsprechend Figur 3 gelagert. Die Führung 10 wird hier durch eine Klemmung realisiert, so dass in achsparalleler Richtung der mittlere Steg zwischen dem linken Schenkel des Leadframes und in dem Energiespeicher 9 keine Verschiebemöglichkeiten hat. In Umfangsrichtung kann sich jedoch dieses Teilstück des Leadframes geringfügig bewegen. Gleichzeitig ist in Figur 4 nochmals die Spielpassung 12 entsprechend am linken Schenkel des Leadframes 1 zu erkennen.

## Patentansprüche

1. Vorrichtung zur Kontaktierung von Kontaktstiften/PIN (4) von Piezoaktoren mit Anschlusselementen zum elektrischen Anschluss von Piezoaktoren nach außen, wobei ein Kunststoffring (60) stirnseitig auf einer Kopfplatte (8) eines Piezostapels (7) positioniert ist, Kontaktstifte (4) durch den Kunststoffring (60) hindurchgeführt sind und nach außen hervorragen, mindestens ein aus einem elektrischen Leiter gebildetes im wesentlichen U-förmig ausgeformtes Verbindungsteil/Leadframe (1) mit seinem mittleren Steg in den Kunststoffring annähernd vollständig eingegossen ist, sodass die nach außen gerichteten Schenkel des Verbindungsteils (1) an sowohl einem Kontaktstift (4) als auch an einem Anschlusselement/Terminaladapter (5) zur Verschweißung positioniert sind,
**dadurch gekennzeichnet dass**,
- das Verbindungsteil (1) unter Beibehaltung seiner U-Form bei analoger Positionierung in Aussparungen im Kunststoffring (60) derart eingepasst ist, dass
- ein Schenkel (14) mittels einer Führung (10) und das angrenzende Teil des mittleren Stegs (13) mittels einer Spielpassung (12) aufgenommen sind, und
- der gegenüberliegende Schenkel (14) und das an diesen angrenzende Teil (13) des mittleren Stegs (13) in umgekehrter Weise mittels einer Spielpassung (12) und mittels einer Führung (10) gelagert sind,
- das Verbindungsteil (1) im mittleren Steg, etwa mittig einen Energiespeicher (9) zur Dämpfung von Schwingungen aufweist.

2. Vorrichtung Anspruch 1, **dadurch gekennzeichnet dass**, der Kunststoffring (60) aus Polyamid besteht.

3. Vorrichtung nach Anspruch 1 oder 2, **dadurch gekennzeichnet dass**, der Kunststoffring (60) in einen oberen Ring (61) und in einen unteren Ring (62) unterteilt ist.

4. Vorrichtung nach einem der vorhergehenden Ansprüche, **dadurch gekennzeichnet dass**, der Energiespeicher als Federelement ausgebildet ist.
